# EUROPEAN PATENT APPLICATION

(11) **EP 3 454 380 A1**
(43) Date of publication of application: **13.03.2019**
(21) Application number: 17815705.3
(22) Date of filing: 21.06.2017
(51) Int. Cl.: H01L 31/0224, H01L 31/04, H01L 31/02, H01L 31/0236, H01L 31/18, H01L 31/0392

(54) **PERL SOLAR CELL AND METHOD FOR PREPARING SAME**

(30) Priority: 23.06.2016 KR 20160078542
(71) Applicant: Hyundai Heavy Industries Green Energy Co., Ltd., Seongnam-si, Gyeonggi-do 13591 (KR)
(72) Inventor: AHN, Jin Hyung, Seongnam-si, Gyeonggi-do 13591 (KR); LIM, Jong Keun, Seongnam-si, Gyeonggi-do 13591 (KR); SEO, Jae Won, Seongnam-si, Gyeonggi-do 13591 (KR); KIM, Moon Seok, Seongnam-si, Gyeonggi-do 13591 (KR); YOON, San Il, Seongnam-si, Gyeonggi-do 13591 (KR)
(74) Representative: Jaeger, Michael David
(86) International application number: PCT/KR2017/006501
(87) International publication number: WO 2017/222292

(57) **Abstract**

The present disclosure relates to a PERL solar cell and a method for preparing same. In forming a back contact electrode, of the PERL solar cell, comprising a BSF metal layer and a bus bar electrode, the PERL solar cell has the BSF metal layer provided on opening portions of a passivation layer and has a bus bar electrode formed on the passivation layer, thereby resolving all mechanical defects generated, when forming the opening portions of the passivation layer, and enhancing the strength of the solar cell. A PERL solar cell, according to the present disclosure, comprises: a solar cell substrate; a passivation layer provided on one side of the substrate and having a plurality of opening portions which expose the surface of the substrate; a bus bar electrode provided on the passivation layer and on an area not overlapping the area on which the opening portions are provided; and a BSF metal layer provided on the passivation layer so as to fill all the plurality of opening portions.

## Description

### [Technical Field]

The present disclosure relates to a PERL solar cell and a method for preparing the same, and more particularly, to a PERL solar cell and a method for preparing the same, in which in forming a back contact electrode, of the PERL solar cell, comprising a BSF metal layer and a bus bar electrode, the PERL solar cell has the BSF metal layer provided on opening portions of a passivation layer and has a bus bar electrode formed on the passivation layer, thereby resolving all mechanical defects generated, when forming the opening portions of the passivation layer, and enhancing the strength of the solar cell.

### [Background Art]

A solar cell is a key element of a photovoltaic power generation that directly converts solar light to electricity, and is basically a p-n junction diode. Seeing the conversion process of solar light to electricity by the solar cell, when solar light enters the p-n junction of the solar cell, electron-hole pairs are produced, and electrons move to n-layer and holes move to p-layer by an electric field to generate a photoelectromotive force at the p-n junction, and when a load or a system is connected to two ends of the solar cell, an electric current flows, producing power.

To improve the photoelectric conversion efficiency of solar cells, solar cells of various structures have been proposed, and one of them is a passivated emitter rear locally diffused (PERL)-type solar cell. A PERL-type solar cell has a structure in which a local semiconductor layer (locally p+) is provided on the back side of a substrate (p-type), a passivation layer is provided on the back side of the substrate including the local semiconductor layer, and a back electrode is provided on the passivation layer (see Korean Patent Publication No. 2012-87022).

In this PERL-type solar cell, a portion of the passivation layer is opened by laser, and the local semiconductor layer and the back electrode are electrically connected through the opening (locally contact).

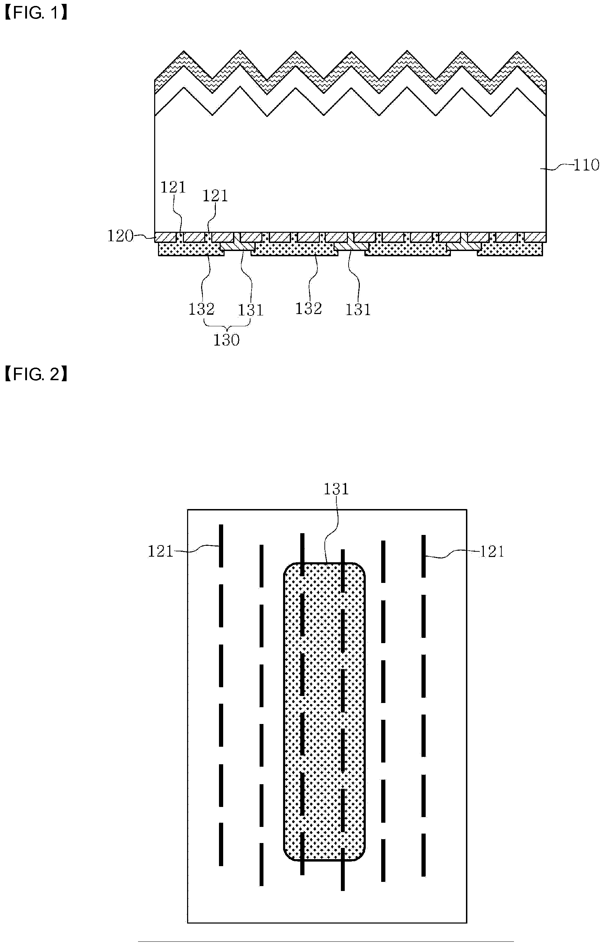

As shown in FIGS. 1 and 2, the back electrode of the PERL solar cell includes an Ag electrode 131 and an Al electrode 132. The Ag electrode 131 corresponds to a bus bar electrode, and the Al electrode 132 is provided on the entire surface of the back side of the substrate except the area in which the Ag electrode 131 is formed. Additionally, both the Ag electrode 131 and the Al electrode 132 contact the surface of the back side of the substrate 110 through the opening 121 of the passivation layer 120.

The Ag electrode and the Al electrode are formed through a sintering process after screen printing, and during sintering, interdiffusion takes place between Al of the Al electrode and Si component of the silicon substrate, forming a back surface field (BSF) (see FIG. 2). In contrast, Ag and Si do not react with each other. Accordingly, in the opening of the passivation layer, BSF is formed by reaction between Al and Si in an area in which Al exists, and Ag and Si do not react in an area in which Ag exists, so there is a boundary between an Ag layer and a Si layer.

Meanwhile, in the process of opening a portion of the passivation layer using laser, mechanical defect such as dislocation occurs in the corresponding portion of the passivation layer due to laser ablation, and the mechanical defect acts as a factor that degrades the strength characteristic of the solar cell.

In the opening of the passivation layer, mechanical defect caused by laser ablation is resolved by BSF in the area in which BSF is formed, but mechanical defect remains in the area in which the Ag electrode is disposed.

### [RELATED LITERATURES]

### [Patent Literatures]

(Patent Literature 1) Korean Patent Publication No. 2012-87022

### [Disclosure]

### [Technical Problem]

The present disclosure is designed to solve the above-described problem, and therefore the present disclosure is directed to providing a PERL solar cell and a method for preparing the same, in which in forming a back contact electrode, of the PERL solar cell, comprising a BSF metal layer and a bus bar electrode, the PERL solar cell has the BSF metal layer provided on opening portions of a passivation layer and has a bus bar electrode formed on the passivation layer, thereby resolving all mechanical defects, generated when forming the opening portions of the passivation layer, and enhancing the strength of the solar cell.

### [Technical Solution]

To achieve the above-described object, a PERL solar cell according to the present disclosure includes a solar cell substrate, a passivation layer provided on one side of the substrate and having a plurality of opening portions which exposes the surface of the substrate, a bus bar electrode provided on the passivation layer and on an area not overlapping the area on which the opening portions are provided, and a BSF metal layer provided on the passivation layer so as to fill all the plurality of opening portions.

The plurality of opening portions is spaced apart in up-down and left-right directions.

A method for preparing a PERL solar cell according to the present disclosure includes preparing a solar cell substrate, stacking a passivation layer on one side of the substrate, selectively removing a portion of the passivation layer to form a plurality of opening portions which exposes the surface of the substrate, coating a first conductive paste forming a bus bar electrode on the passivation layer of an area not overlapping the area on which the opening portions are provided, coating a second conductive paste for forming a BSF metal layer on the passivation layer so as to fill all the plurality of opening portions, and sintering the substrate to form a bus bar electrode and a BSF metal layer.

The first conductive paste is converted to a bus bar electrode, the second conductive paste is converted to a metal layer, and a conductive material of the second conductive paste is diffused into the substrate through the opening portions of the passivation layer to form a BSF layer.

### [Advantageous Effects]

The PERL solar cell according to the present disclosure and the method for preparing the same have the following effect.

While the bus bar electrode containing Ag as the main component avoids contact with the opening portions of the passivation layer, all the opening portions of the passivation layer are filled by the BSF metal layer containing Al as the main component, and the BSF layer is formed around all the opening portions, and thus all mechanical defects generated around the opening portions by laser ablation are resolved, and as a consequence, the mechanical strength of the solar cell may be enhanced.

### [Description of Drawings]

FIG. 1 is a configuration diagram of a PERL solar cell according to the related art.
FIG. 2 is a bottom view of a PERL solar cell according to the related art.
FIG. 3 is a configuration diagram of a PERL solar cell according to an embodiment of the present disclosure.
FIGS. 4A to 4E are process reference diagrams illustrating a method for preparing a PERL solar cell according to an embodiment of the present disclosure.
FIGS. 5A to 5D are bottom views of a PERL solar cell according to an embodiment of the present disclosure.

### [Best Mode]

In implementing a PERL solar cell, mechanical defect occurs in a solar cell substrate due to laser ablation when forming an opening portion, and the mechanical defect acts as a factor that weakens the mechanical strength of the solar cell.

The present disclosure proposes forming a bus bar electrode that does not serve to resolve mechanical defect of a solar cell substrate only on a passivation layer while avoiding contact with opening portions, and filling all the opening portions on the substrate with a BSF metal layer that serves to resolve mechanical defect, thereby resolving mechanical defect generated when forming an opening portion, and increasing the mechanical strength of the solar cell.

Specifically, the present disclosure proposes, in implementing a PERL solar cell, filling all opening portions of a passivation layer with a BSF metal layer such that the opening portion area of the passivation layer does not overlap with an area in which a bus bar electrode is provided, thereby resolving mechanical defects around the opening portions by the BSF layer.

The present disclosure may be applied to a front-junction PERL solar cell having an emitter layer disposed above a substrate as well as a back-junction PERL solar cell having an emitter layer disposed below a substrate. The following description is made on the basis of a front-junction PERL solar cell.

Hereinafter, a PERL solar cell according to an embodiment of the present disclosure and a method for preparing the same will be described in detail with reference to the accompanying drawings.

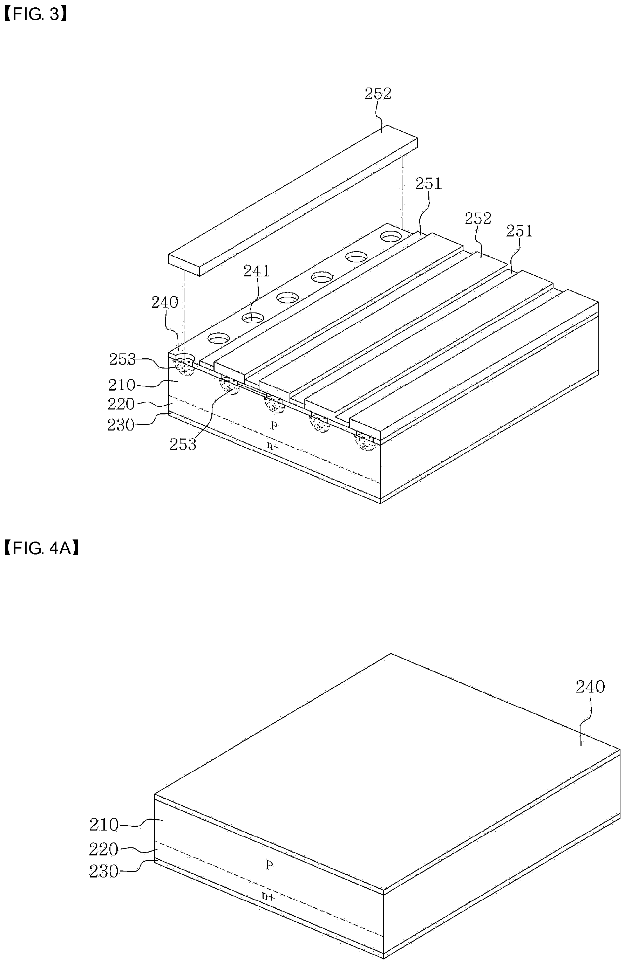

Referring to FIG. 3, the PERL solar cell according to an embodiment of the present disclosure has a passivation layer 240 on the back side of a substrate 210.

The passivation layer 240 is provided on the back side of the substrate 210 and primarily plays a role of surface passivation, and may be formed from an aluminum oxide film (AlOₓ), a silicon oxide film (SiOₓ) or a silicon nitride film (SiNₓ). Meanwhile, the substrate 210 is a first conduction-type (e.g., p-type) silicon substrate 210, a second conduction-type (e.g., n-type) emitter layer 220 is provided in the upper part within the substrate 210, and an antireflection film 230 is provided on the front side of the substrate 210. Additionally, a front contact electrode (not shown) that is electrically connected to the emitter layer 220 is provided on the antireflection film 230.

The passivation layer 240 has a plurality of opening portions 241, and the back side surface of the substrate 210 is exposed by the opening portions 241. The plurality of opening portions 241 is arranged, spaced apart at a predetermined interval, along the left-right and up-down directions on the basis of the plane of the passivation layer 240.

A back contact electrode is provided on the front side of the passivation layer 240 including the opening portions 241. That is, the plurality of opening portions 241 provided in the passivation layer 240 is filled by the back contact electrode. Specifically, the back contact electrode includes a BSF metal layer and a bus bar electrode 251.

The BSF metal layer collects carriers produced by photoelectric conversion within the substrate 210, and includes a metal layer 252 on the back side of the substrate 210 to induce the formation of a back surface field (BSF) layer, as well as a BSF layer 253.

The BSF layer 253 formed within the substrate 210 plays a role of preventing the recombination while the carriers within the substrate 210 moves to the metal layer 252, and the metal layer 252 plays a role of collecting the carriers moved through the BSF layer 253. When the substrate 210 is p-type, the metal layer 252 is made of Group 3 metal element, for example, Al, and the BSF layer 253 is formed by diffusion of Group 3 metal element of the metal layer 252 into the substrate 210. When the substrate 210 is n-type, the metal layer 252 and the BSF layer 253 are made of Group 5 metal element.

The metal layer 252 is provided on the passivation layer 240 such that the metal layer 252 fills the opening portions 241 of the passivation layer 240, and the BSF layer 253 is formed in radial shape on the basis of the opening portions 241 of the passivation layer 240. In this instance, all the opening portions 241 of the passivation layer 240 are filled by the metal layer 252.

The bus bar electrode 251 plays a role of transferring the carriers collected by the BSF metal layer to a capacitor outside a module through interconnector (not shown), and is made of Ag component or includes Ag component. Generally, the solar cell is connected to the external device through 2-12 interconnectors, and one interconnector is connected to 1-10 bus bar electrodes 251.

The BSF metal layer is provided such that the BSF metal layer fills the opening portions 241 of the passivation layer 240, while the bus bar electrode 251 is only provided on the passivation layer 240. That is, the bus bar electrode 251 is not disposed in the opening portions 241 of the passivation layer 240, and does not contact with the surface of the back side of the substrate 210 through the opening portions 241 of the passivation layer 240.

The reason why the opening portions 241 of the passivation layer 240 are filled by the BSF metal layer and the bus bar electrode 251 is only provided on the passivation layer 240 is to resolve mechanical defect generated by laser ablation when forming the opening portions 241 of the passivation layer 240 through formation of the BSF layer 253. As described in 'Background Art', during sintering, Al reacts with Si component of the substrate 210, forming BSF, and mechanical defects around the opening portions 241 are resolved by formation of the BSF, but the main component Ag of the bus bar electrode 251 does not cause a reaction with Si of the substrate 210. Accordingly, to resolve mechanical defects around the opening portions 241 of the passivation layer 240, it is most desirable to avoid contact of Ag and Si and induce contact of Al and Si. For reference, the reaction of Al and Si or the reaction of Ag and Si refers to solid state diffusion reaction at high temperature.

As described above, because the bus bar electrode 251 containing Ag as the main component is only provided on the passivation layer 240, the contact with the surface of the back side of the substrate 210 is avoided, and because the BSF metal layer containing Al as the main component is provided such that the BSF metal layer fills all the opening portions 241 of the passivation layer 240, the mechanical defects such as dislocation around the opening portions 241 generated when forming the opening portions 241 are resolved by formation of the BSF layer 253, and as the mechanical defects are resolved, the strength characteristic of the solar cell are enhanced.

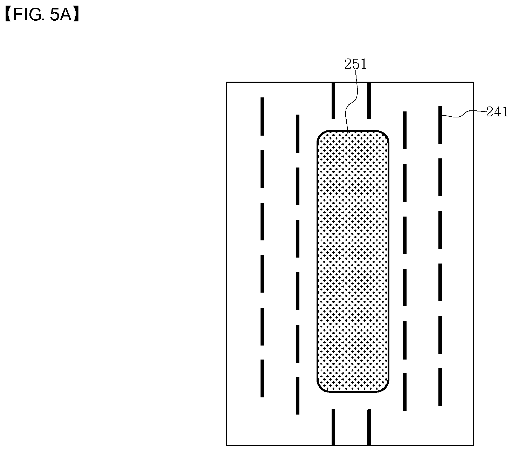

The bus bar electrode 251 provided only on the passivation layer 240, avoiding contact with the opening portions 241 of the passivation layer 240, may be formed in various shapes as shown in FIGS. 5A to 5E under the premise that a condition to avoid contact with the opening portions 241 is satisfied. The bus bar electrode 251 may be provided on the area between the opening portions 241, or the location at which the opening portions 241 are provided may be changed depending on the shape of the bus bar electrode 251. The embodiment of FIGS. 5A to 5E will be described in detail below.

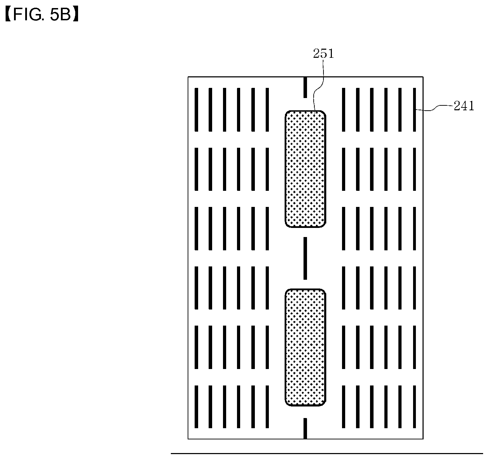

FIG. 5A shows the structure in which one bus bar electrode 251 is provided, and the plurality of opening portions 241 is uniformly formed in an area where the bus bar electrode 251 is not provided. FIG. 5B shows the structure in which two bus bar electrodes 251 are spaced apart from each other in an area where the interconnectors are arranged, the plurality of opening portions 241 is uniformly formed in an area where the interconnectors are not arranged, and the density and the area of the opening portions 241 in the area where the interconnectors are arranged is smaller than opening portions in other areas. In the structure of FIG. 5B, the interconnectors are disposed symmetrically at the same location of the front side and the back side with respect to the solar cell substrate, and carrier generation reduces in the region where the interconnectors are disposed because incident light is shielded by the interconnectors. Accordingly, this region reduces the density of the opening portions 241 and reduces the charge collection level, and instead, can increase the area that is passivated by passivation, reduce a recombination loss and increase the cell efficiency. The reduced density of the opening portions 241 varies depending on the conductivity of the substrate, the resistance of the metal layer 252 and the width of the interconnector and may be optimized based on the given cell specification and design.

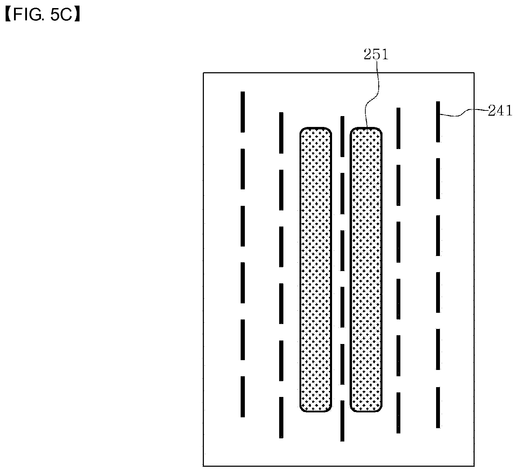

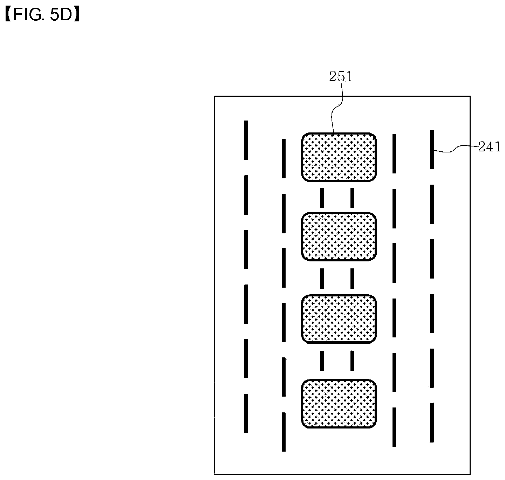

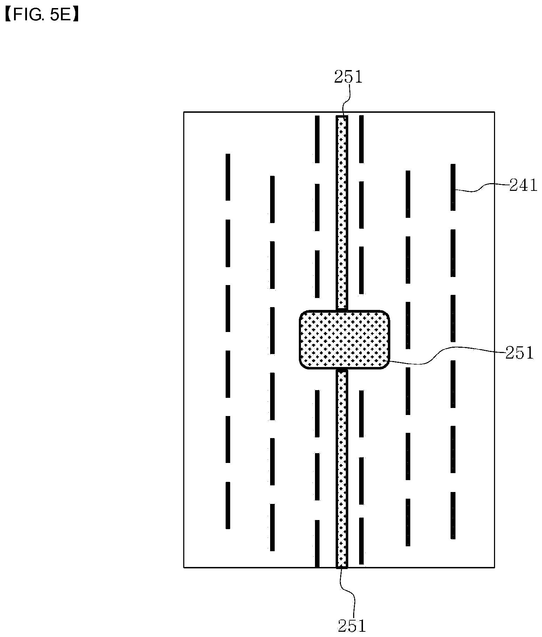

FIGS. 5C and 5D show the positional relationship between unit bus bar electrodes and the opening portions 241 in case that the bus bar electrode includes a plurality of unit bus bar electrodes arranged, spaced apart from each other, and FIG. 5E shows the positional relationship between the bus bar electrodes 251 and the opening portions 241 in the structure in which the bus bar electrodes 251 disposed below the same interconnector are connected to collect the electric current well.

Meanwhile, in FIGS. 5A to 5E, the metal layer 252 that forms the BSF layer 253 is formed on the back side of the substrate in which the opening portions 241 and the bus bar electrode 251 are formed, such that the metal layer 252 fills all the opening portions 241. The metal layer 252 and the bus bar electrode 251 are provided on different areas, and to improve the ohmic contact characteristics of the metal layer 252 and the bus bar electrode 251, the area in which the metal layer 252 is provided and the area in which the bus bar electrode 251 is provided may overlap at a predetermined part.

Meanwhile, the BSF metal layer and the bus bar electrode 251 are provided on different areas, and to improve the ohmic contact characteristics of the BSF metal layer and the bus bar electrode 251, the area in which the BSF metal layer is provided and the area in which the bus bar electrode 251 is provided may overlap at a predetermined part.

The PERL solar cell according to an embodiment of the present disclosure has been hereinabove described. A method for preparing a PERL solar cell to an embodiment of the present disclosure will be described below.

First, as shown in FIG. 4A, a solar cell substrate 210 is prepared.

The substrate 210 is a first conduction-type (e.g., p-type) silicon substrate 210, and a second conduction-type (e.g., n-type) emitter layer 220 is provided in the upper part within the substrate 210, and an antireflection film 230 is provided on the front side of the substrate 210. Additionally, a front contact electrode that is electrically connected to the emitter layer 220 may be provided on the antireflection film 230.

When the substrate 210 is prepared, a passivation layer 240 is stacked on the entire surface of the back side of the substrate 210. The passivation layer 240 may be stacked through chemical vapor deposition (CVD), and may be formed from a silicon oxide film or a silicon nitride film.

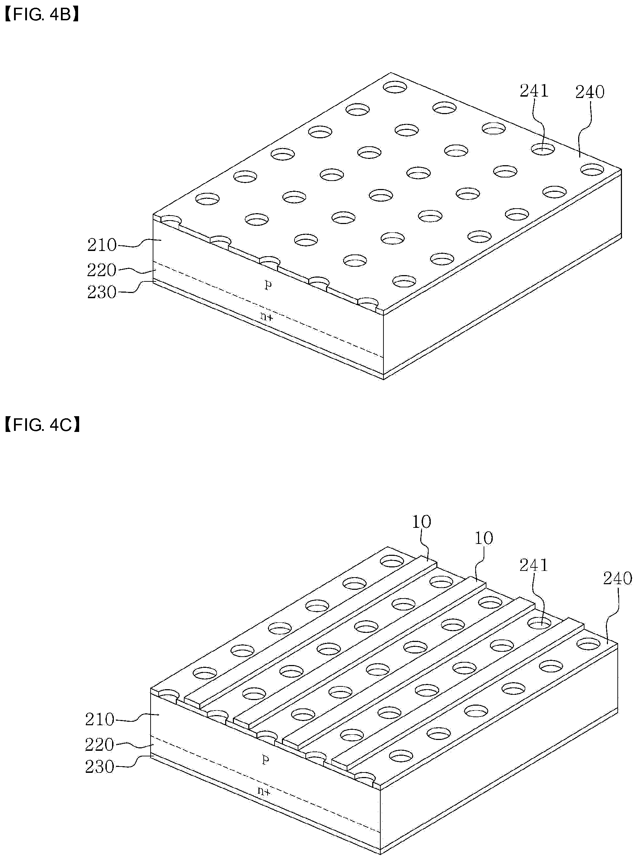

When the passivation layer 240 is stacked, a portion of the passivation layer 240 is selectively removed to form a plurality of opening portions 241 that exposes the surface of the back side of the substrate 210 (see FIG. 4B). The plurality of opening portions 241 may be spaced apart at a predetermined interval, and in an embodiment, may be arranged, spaced apart along the left-right direction and up-down direction on the basis of the plane of the passivation layer 240. Additionally, the opening portions 241 may be formed by laser ablation.

The plurality of opening portions 241 does not overlap with a bus bar electrode 251 as described below, and under this condition, it is possible to variously design the location at which the plurality of opening portions 241 is formed depending on the location at which a bus bar electrode 251 is formed.

When the plurality of opening portions 241 that selectively exposes the surface of the back side of the substrate 210 is formed in the passivation layer 240, a process of forming a back contact electrode is performed.

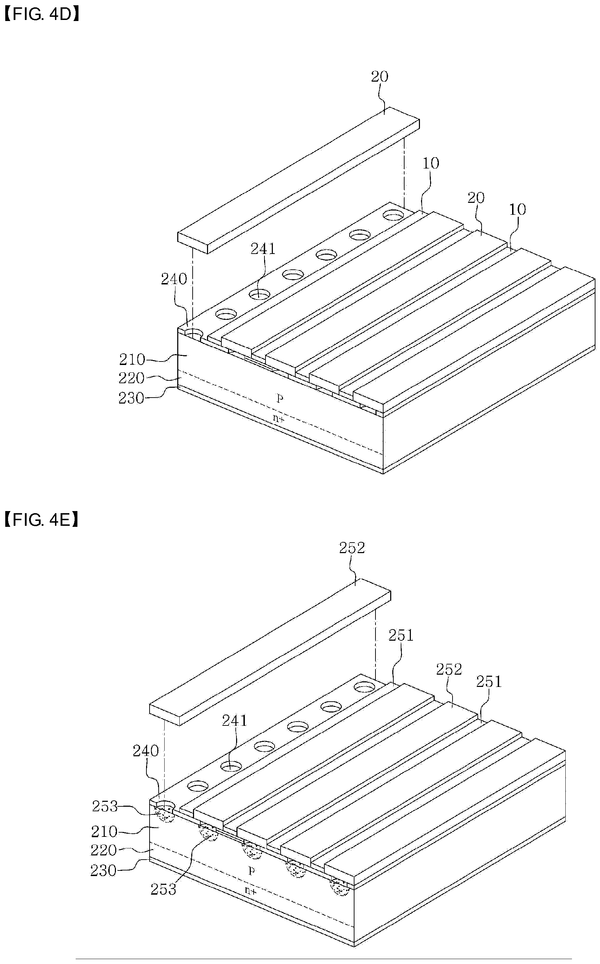

First, a first conductive paste 10 for forming a bus bar electrode 251 is coated on the passivation layer 240 (see FIG. 4C). An area in which the first conductive paste 10 is coated does not overlap with an area in which the opening portions 241 are disposed. Subsequently, a second conductive paste 20 for forming a BSF metal layer is coated on the passivation layer 240 that is not coated with the first conductive paste 10 (see FIG. 4D). The second conductive paste 20 is coated on the passivation layer 240, and is coated such that the second conductive paste 20 fills all the opening portions 241 of the passivation layer 240. In this instance, the first conductive paste 10 and the second conductive paste 20 may be coated such that predetermined parts overlap at the boundaries.

The first conductive paste 10 may contain Ag as its main component and the second conductive paste 20 may contain Al as its main component, and the first conductive paste 10 and the second conductive paste 20 may be coated through a screen printing method.

When the first conductive paste 10 and the second conductive paste 20 are coated, the substrate 210 is sintered at a predetermined temperature (see FIG. 4E). By the sintering, the first conductive paste 10 is converted to a bus bar electrode 251, and the second conductive paste 20 is converted to a metal layer 252. Additionally, the conductive material Al of the second conductive paste 20 is diffused into the substrate 210 through the opening portions 241 of the passivation layer 240 to form a BSF layer 253. The resulting bus bar electrode 251 does not overlap with the opening portions 241, all the opening portions 241 of the passivation layer 240 are filled by the metal layer 252, and the BSF layer 253 is formed in the substrate 210 that touches the opening portions 241, and thus mechanical defects around the opening portions 241 caused by laser ablation are resolved by the BSF layer 253.

### [Detailed Description of Main Elements]

| | |
|---|---|
| 10: First conductive paste | 20: Second conductive paste |
| 210: Substrate | 220: Emitter layer |
| 230: Antireflection film | 240: Passivation layer |
| 241: Opening portion | 251: Bus bar electrode |
| 252: Metal layer | 253: BSF layer |

### [Industrial Applicability]

While the bus bar electrode containing Ag as the main component avoids contact with the opening portions of the passivation layer, all the opening portions of the passivation layer are filled by the BSF metal layer containing Al as the main component, and the BSF layer is formed around all the opening portions, and thus all mechanical defects generated around the opening portions by laser ablation are resolved.

## Claims

1. A PERL solar cell, comprising:
a solar cell substrate;
a passivation layer provided on one side of the substrate and having a plurality of opening portions which exposes the surface of the substrate;
a bus bar electrode provided on the passivation layer and on an area not overlapping the area on which the opening portions are provided; and
a BSF metal layer provided on the passivation layer so as to fill all the plurality of opening portions.

2. The PERL solar cell according to claim 1, wherein the plurality of opening portions is spaced apart in up-down and left-right directions.

3. A method for preparing a PERL solar cell, comprising:
preparing a solar cell substrate;
stacking a passivation layer on one side of the substrate;
selectively removing a portion of the passivation layer to form a plurality of opening portions which exposes the surface of the substrate;
coating a first conductive paste forming a bus bar electrode on the passivation layer of an area not overlapping the area on which the opening portions are provided;
coating a second conductive paste for forming a BSF metal layer on the passivation layer so as to fill all the plurality of opening portions; and
sintering the substrate to form a bus bar electrode and a BSF metal layer.

4. The method for preparing a PERL solar cell according to claim 3, wherein the first conductive paste is converted to a bus bar electrode, the second conductive paste is converted to a metal layer, and a conductive material of the second conductive paste is diffused into the substrate through the opening portions of the passivation layer to form a BSF layer.
